# EUROPEAN PATENT APPLICATION

(11) **EP 4 530 691 A1**
(43) Date of publication of application: **02.04.2025**
(21) Application number: 24202495.8
(22) Date of filing: 25.09.2024
(51) Int. Cl.: G02B 6/42, H10F 55/20

(54) **MANUFACTURING METHOD OF PACKAGING SUBSTRATE AND PACKAGING SUBSTRATE USING THE SAME**

(30) Priority: 27.09.2023 US 202363540931 P
(71) Applicant: Absolics Inc., Covington, GA 30014 (US)
(72) Inventor: KIM, Sungjin, Covington, Georgia, 30014 (US); KIM, Tae Kyoung, Covington, Georgia, 30014 (US)
(74) Representative: BCKIP Part mbB

(57) **Abstract**

The present disclosure relates to a manufacturing method for a packaging substrate and a packaging substrate utilizing the method. The packaging substrate according to the present disclosure includes; a core layer including a glass substrate having first and second surfaces facing each other and a cavity portion; an insulating layer formed on the first surface; and a light transmitting portion formed on an upper surface of the insulating layer, wherein a light receiving portion is disposed in the cavity portion, the insulating layer includes a via penetrating in a thickness direction, and a portion of a lower surface of the light transmitting portion may abut on the via. Though it, the packaging substrate may be compactly manufactured by reducing the space for the configuration of electrically connecting the conventional photoelectric elements, and the effect of improving the sensing efficiency and performance of the photoelectric sensor relative to the space may occur.

## Description

This application claims the priority of U.S. Provisional Patent Application No. 63/540,931, filed September 27, 2023.

### BACKGROUND

### 1. Field

This document relates to a packaging substrate, a semiconductor package, a manufacturing method for a packaging substrate, and a manufacturing method for a semiconductor package.

### 2. Description of Related Art

In manufacturing electronic components, implementing a circuit on a semiconductor wafer is called the front-end process (FE), and assembling the wafer into a state that can be used in an actual product is called the back-end process (BE: Back-End). The packaging process is included in the latter process.

The four core technologies of the semiconductor industry that have recently enabled the rapid development of electronic products include semiconductor technology, semiconductor packaging technology, manufacturing process technology, and software technology. Semiconductor technology is developing in various forms, such as line widths of micro or nanoscale, more than 10 million cells, high-speed operation, and high heat dissipation, but the technology to package it perfectly is relatively unsupported. Accordingly, the electrical performance of a semiconductor is determined by packaging technology and the resulting electrical connection rather than the performance of the semiconductor technology itself.

Packaging Substrates can be made of ceramic or resin. Ceramic substrates, such as silicon substrates, have high resistivity or high dielectric constant, making it difficult to mount high-performance, high-frequency semiconductor elements. In the case of resin substrates, it is possible to mount relatively high-performance, high-frequency semiconductor elements. However, there are limitations in reducing the pitch of the wiring.

Recently, silicon or glass can be used as substrates for high-end packaging. By forming through-holes in the silicon substrate or glass substrate and applying conductive materials to the through-holes, the wiring between the element and the motherboard can be shortened and have good electrical characteristics.

Relevant prior art includes Japanese Patent Publication JP 2022-108493A and Korean Patent Publication No. 10-2020-0100887.

### SUMMARY

An object of the embodiments is to provide a packaging substrate in which a glass substrate is applied, a manufacturing method for a packaging substrate in which signals are transmitted and received between photoelectric devices using a property of the glass substrate to pass signals in the form of light energy, and a packaging substrate using the method.

It is also an object of the embodiments to provide a manufacturing method of a packaging substrate that enables signals in the form of light energy to be transmitted and received between photoelectric devices through a glass substrate, and a packaging substrate using the method of manufacturing the packaging substrate that is compactly fabricated by reducing the space for constructing electrical connection structures.

To achieve the above objectives, a packaging substrate according to one embodiment may include a core layer including a glass substrate having first and second surfaces facing each other and a cavity portion, an insulating layer formed on the first surface, and a light transmitting portion formed on an upper surface of the insulating layer, wherein a light receiving portion is disposed in the cavity portion, the insulating layer includes a via penetrating in a thickness direction, and a portion of a lower surface of the light transmitting portion abuts the via.

A signal of photo-energy output from the light transmitter portion may pass through the glass substrate to the light receiving portion.

The signal of photo-energy may include visible light or infrared light.

The width of the via may be from about 10 µm to about 500 µm.

The vias may contain a vacuum or an inert gas.

The vias may include air or light-transmissive material.

The light transmissive material may have a coefficient of thermal expansion of about 10 24 ppm/°C to about 24 ppm/°C.

The cavity portion may be open toward the second surface of the glass substrate and formed in the form of a recessed surface to provide a space in which the light receiving portion is disposed.

To achieve the purpose, a manufacturing method of a packaging substrate according to one embodiment may include operations of creating a cavity portion in a glass substrate having first surface and second surface facing each other, placing a light receiving portion in the cavity portion, forming an insulating layer on the first surface, creating a via in the insulating layer, and laminating a light transmitting portion on the insulating layer, characterized in that a portion of a lower surface of the light transmitting portion abuts the via.

A signal of photo-energy output from the light transmitting portion may pass through the glass substrate to the light receiving portion.

The signal of photo-energy may include visible light or infrared light.

The width of the via may be from 10 µm to 500 µm.

The via may contain a vacuum or an inert gas.

The via may include air or light-transmissive material.

The light transmissive material may have a coefficient of thermal expansion of about 10 ppm/°C to about 24 ppm/°C.

The cavity portion may be open toward the second surface of the glass substrate and formed in the form of a recessed surface to have a space in which the light receiving portion is disposed.

### BRIEF DESCRIPTION OF THE DRAWINGS

FIG. 1 is a conceptual diagram illustrating a cross-sectional structure of a packaging substrate, according to an embodiment.
FIG. 2 is a conceptual diagram illustrating a cross-sectional structure of a packaging substrate, according to another embodiment.
(a) and (b) of FIG. 3 are conceptual diagrams illustrating a cross-sectional view of a portion of a packaging substrate, according to an embodiment, respectively.
(a) through (e) of FIG. 4 are flowcharts illustrating, in cross-section, a process for creating a core distribution layer during the manufacture of a packaging substrate, according to an embodiment.
(a) through (e) of FIG. 5 are flowcharts illustrating, in cross-section, a process for creating an insulating layer during manufacturing of a packaging substrate, according to an embodiment.

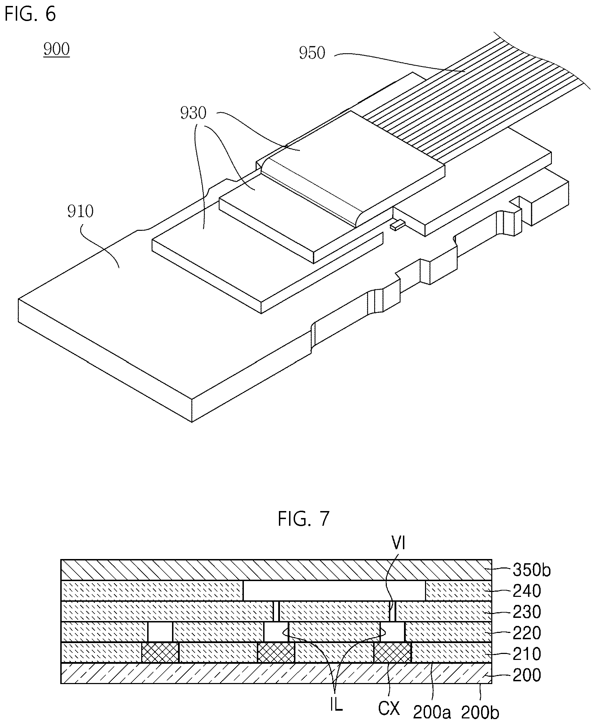

FIG. 6 is an exemplary drawing of a packaging substrate comprising a conventional photoelectric sensor and an apparatus having the same.
FIG. 7 is a conceptual diagram illustrating an exemplary cross-sectional structure of a packaging substrate comprising a conventional photoelectric sensor.

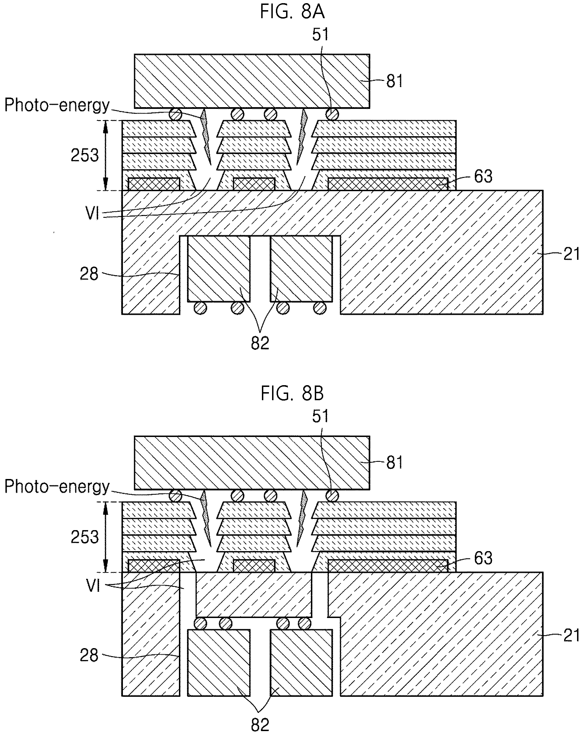

FIGS. 8A through 8D are each example of a cross-sectional structure of a packaging substrate generated in accordance with an embodiment.

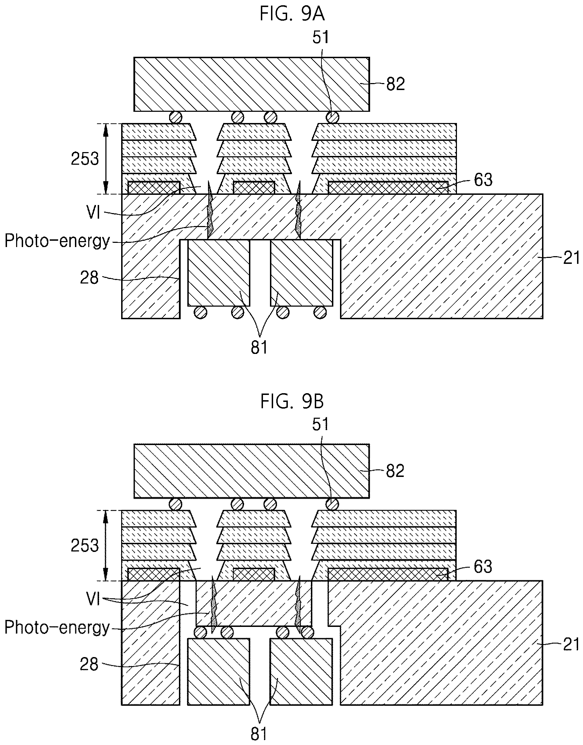

FIGS. 9A through 9D are examples of cross-sectional structures of a packaging substrate generated in accordance with different embodiments.

### DETAILED DESCRIPTION

In order to provide a comprehensive understanding of the methods, apparatus, and/or systems described herein, the following detailed description is provided. However, various modifications, alterations, and equivalents of the methods, devices, and/or systems described herein will become apparent after understanding what this disclosure presents. For example, the sequence of operations described herein is by way of example only and is not intended to be limiting to the operations described herein. Except for steps that necessarily proceed in a certain order, the order of operations may be changed according to the understanding of the contents presented by the present application. In addition, the description of known features may be omitted to increase clarity and brevity after understanding the disclosure of the present application. However, it is not intended to recognize the feature and the omission of the description as general knowledge.

The features described herein may be implemented in different forms and are not to be construed as being limited to the examples described herein. Rather, the embodiments described herein are provided to illustrate some of the many possible ways of implementing the methods, devices, and/or systems described herein that will become apparent after understanding the disclosures of this application.

The terms "first," "second," "third," and the like may be used herein to describe various members, components, regions, layers, or sections, but are not intended to limit the members, components, regions, layers, or sections to these words. Instead, these terms are used for the purpose of distinguishing one member, component, region, layer, or section from another member, component, region, layer, or section. Thus, a first member, component, region, layer, or section referred to in the embodiments described herein may also be referred to as a second member, component, region, layer, or section without departing from the teachings of the embodiments.

Throughout the specification, when an element, such as a layer, region, or substrate, is described as being "on," "connected to," or "coupled to" another element, it may be described as being directly "on," "connected to," or "coupled to" the other element, or it may have one or more other elements interposed between them. In contrast, when an element is described as "directly on", "directly connected to", or "directly joined to" another element, no other element can intervene between them. Similarly, for example, expressions such as "between" and "directly between," and "abutting" and "directly abutting" can also be interpreted as described above.

The terms used in this specification are intended to describe specific examples and are not intended to limit disclosure. The singular form used herein is intended to include the plural form unless the context clearly indicates otherwise. As used herein, the term "and/or" includes any one or a combination of two or more of the relevant list items. The terms "comprising," "consisting of," and "having" as used herein specify the presence of the specified features, numbers, actions, elements, components, and/or combinations thereof, but do not exclude the presence or addition of one or more other features, numbers, actions, elements, components, and/or combinations thereof. The use of the term "may" in this specification with respect to an example or embodiment (e.g., with respect to what an example or embodiment may include or implement) implies that there is at least one example or embodiment that includes or implements such features, but not all examples are limited thereto.

For the purposes of this application, "B being located on A" means that B is placed on top of A, either in direct contact with A or with another layer or structure interposed therebetween, and should not be construed to mean that B is in direct contact with A.

Unless otherwise defined, all terms used herein shall have the same meaning as commonly understood by one of ordinary skill in the art to which the present invention belongs. Such terms, as defined in commonly used dictionaries, shall be construed to have a meaning consistent with their meaning in the context of the prior art and the present invention and shall not be construed in an idealized or overly formal sense unless expressly defined herein.

In one or more of the examples above, a description of "A and/or B" means "A, B, or A and B".

In one or more of the above examples, terms such as "first," "second," "A," or "B" are used to distinguish identical terms from each other.

In one or more of the above examples, singular forms are contextually interpreted to include the plural as well as the singular, unless otherwise noted.

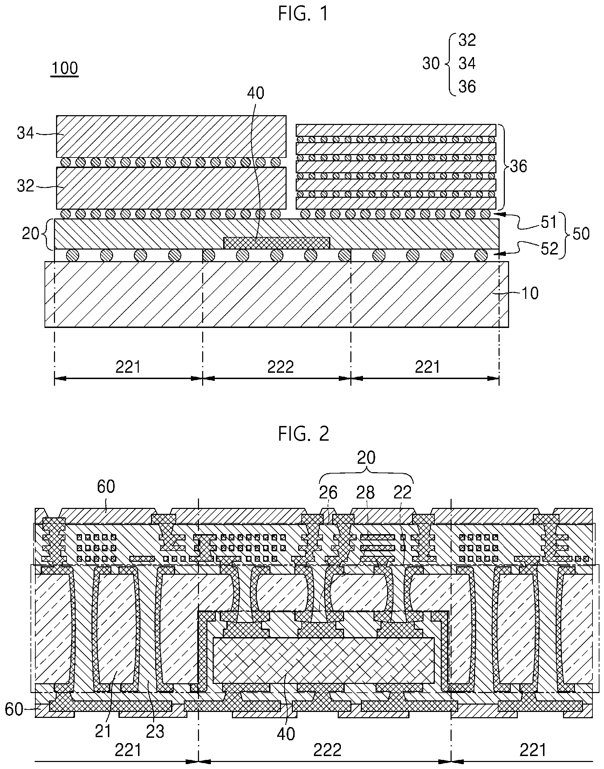

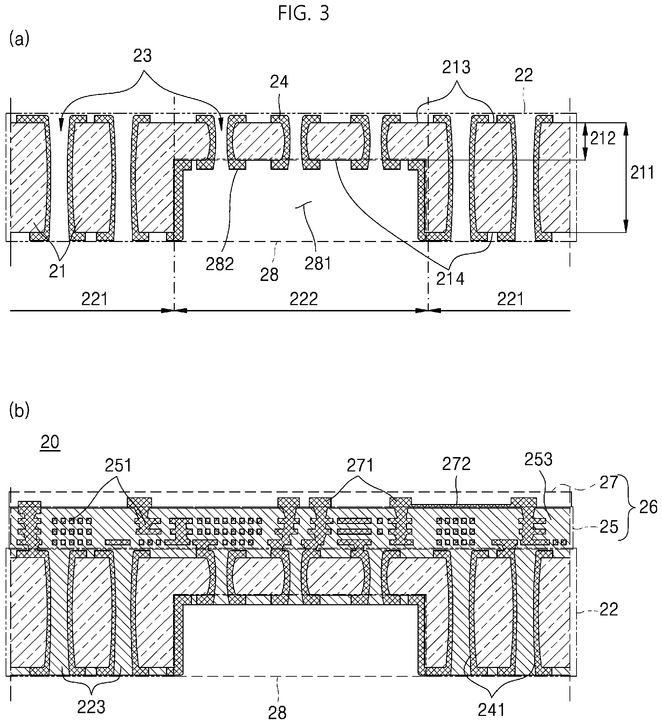

FIG. 1 is a conceptual diagram illustrating a cross-sectional structure of a packaging substrate according to an embodiment, FIG. 2 is a conceptual diagram illustrating a cross-sectional structure of a packaging substrate according to another embodiment, and (a) and (b) of FIG. 3 are conceptual diagrams illustrating cross-sections of portions of a packaging substrate according to embodiments, respectively.

To accomplish the above objectives, a semiconductor device 100 according to an embodiment comprises a semiconductor element portion 30 on which one or more semiconductor elements 32, 34, 36 are located; a packaging substrate 20 electrically connected to the semiconductor elements; and a motherboard 10 electrically connected to the packaging substrate 20 and transmitting external electrical signals to and connecting the semiconductor elements 32, 34, 36 with each other.

The packaging substrate 20, according to one embodiment, comprises a core layer 22, an upper layer 26 located on a first surface of the core layer 22, and a cavity portion 28 in which a cavity element 40 may be located.

The semiconductor element portion 30 refers to elements mounted on a semiconductor device and is mounted on the packaging substrate 20 by means of a connection electrode or the like. Specifically, the semiconductor element portion 30 can be applied to, for example, a computing element (first element: 32, second element: 34) such as a CPU or GPU, a memory element (third element, 36) such as a memory chip, etc. Any semiconductor element mounted on a semiconductor device may be applied without limitation.

The motherboard 10 may be a motherboard such as a printed circuit board, a printed wiring board, or the like.

The packaging substrate 20 may optionally further comprise a lower layer (not shown) positioned below the core layer.

The core layer 22 comprises a glass substrate 21 comprising a first region 221 having a first thickness 211 and a second region 222 having a second thickness 212 adjacent to the first region 221 wherein the second thickness is less than the first thickness; a plurality of core vias 23 penetrating the glass substrate 21 in a thickness direction, and a core distribution layer 24 located on a surface of the glass substrate 21 or core vias 23 and electrically connecting a first surface 213 and a second surface 214 of the glass substrate 21 through the core vias 23 wherein the first surface 213 and the second surface 214 facing each other.

The second region 222 of the core layer 22 may serve as a cavity structure.

Within the same region, the glass substrate 21 has a first surface 213 and a second surface 214 that face each other, and these two surfaces are substantially parallel to each other and have a constant thickness throughout the glass substrate 21.

The internal space 281 formed by the difference in thickness of the first region 221 and the second region 222 serves to house some or all of the cavity elements 40.

The glass substrate 21 may comprise core vias 23 penetrating the first surface 213 and the second surface 214. The core vias 23 may be formed in both the first region 221 and the second region 222 and may be formed in any desired pitch and pattern.

As a packaging substrate for semiconductor devices, silicon substrates and organic substrates have traditionally been applied in a laminated form. In the case of silicon substrates, due to the nature of semiconductors, parasitic elements may occur when applied to high-speed circuits, and power losses are relatively high. In addition, organic substrates require large area to form more complex distribution patterns, which is inconsistent with the trend of miniaturization of electronic devices. In order to form a complex distribution pattern within a certain size, pattern refinement is practically necessary, but there were practical limitations in pattern refinement due to the characteristics of materials such as polymers applied to organic plates.

In an embodiment, a glass substrate 21 is applied as a support body for the core layer 22 as a way to address these issues. In addition, a core via 23 formed through the glass substrate 21 is applied along with the glass substrate 21 to provide the packaging substrate 20 with shorter electrical flow lengths, more miniaturization, faster response, and lower loss characteristics.

The glass substrate 21 is preferably a glass substrate applied to semiconductors, such as, but not limited to, a borosilicate glass substrate, an alkali-free glass substrate, and the like.

The core via 23 penetrates the glass substrate 21. The core via 23 may be formed in such a way as to remove a predetermined area of the glass substrate 21, in particular by etching the plate glass by physical and/or chemical means.

Specifically, the formation of the core via 23 may be accomplished by forming defects (flaws) on the surface of the glass substrate by means of a laser or the like, followed by chemical etching, laser etching, and the like, but is not limited to.

The number of the core vias 23 may be 100 to 3,000, may be 100 to 2,500, or may be 225 to 1,024, based on a unit area (1 cm x 1 cm) of the glass substrate 21. If these pitch conditions are satisfied, the formation of an electrically conductive layer or the like and the performance of the packaging substrate can be improved.

The core distribution layer 24 comprises a core distribution pattern 241, which is an electrically conductive layer electrically connecting the first and second surfaces of the glass substrate via through-vias, and a core insulating layer 223 surrounding the core distribution pattern. The core layer 22 has an electrically conductive layer formed therein through the core vias, which acts as an electrical pathway across the glass substrate 21 and can connect the upper and layer of the glass substrate over a relatively short distance, resulting in faster electrical signal transfer and low loss. The electrically conductive layer may be, for example, but not limited to, a copper plating layer.

The cavity portion 28 is substantially circular, triangular, square, hexagonal, octagonal, cross-shaped, or otherwise non-limiting in shape.

The cavity element 40 may be generally cylindrical, cuboidal, or polygonal in shape.

The cavity portion 28 may comprise a cavity distribution pattern, which is an electrically conductive layer electrically connecting the cavity element 40 and the core distribution layer 24, and an insulating layer surrounding the cavity distribution pattern.

On the other hand, a cavity portion according to another embodiment may be implemented in a form that penetrates the first surface 213 and the second surface 214 of the glass substrate 21. In this case, the cavity portion may be formed according to the same process as the process of forming a core vias 23, and may differ from the core vias 23 in the area and shape that it penetrates the glass substrate 21.

In such an embodiment, an insulating layer may be generated in the cavity portion after it is arranged in the cavity element 40, i.e., an insulating layer may be generated in the cavity portion through the process of generating the core insulating layer 223 described above.

The core distribution pattern 241 may be patterned to be electrically coupled to the cavity element 40.

The cavity element 40 may comprise an active element, such as a transistor, or a passive element, such as a power transfer element, a multilayer ceramic capacitor (MLCC).

If an element such as a transistor, which plays a role in converting electrical signals between the motherboard and the semiconductor element portion to an appropriate level, is applied to the cavity element 40, the packaging substrate 20 can be formed in a form in which a transistor or the like is applied in the way of the packaging substrate 20, thereby providing a semiconductor device 100 having a more efficient and faster speed.

In addition, power transfer elements, such as multilayer ceramic capacitors (MLCCs), play an important role in the performance of semiconductor devices. It is common for at least 200 or more power transfer elements, which are passive elements, to be applied to a semiconductor device, and their performance in transferring power is also affected by the characteristics of the electrically conductive layer surrounding the element. In one embodiment, non-circular shaped core via may be applied where a low resistance electrically conductive layer is required, such as in power transfer elements.

On the other hand, the cavity element 40 may be applied by inserting a passive element such as a capacitor individually, or a group of elements comprising a plurality of passive elements in a form embedded between an insulator layer (cavity element insulation layer), and the electrodes may be formed to be exposed and inserted into the cavity element. The latter option is more workable for packaging substrate fabrication and more favorable for ensuring that the insulating layer is sufficiently and reliably located in the space between complex elements.

The glass substrate 21 plays an intermediate role, an intermediary role, connecting the semiconductor element portion 30 and the motherboard 10 on the upper and lower surfaces, respectively, and the core via 23 acts as a passageway for transmitting electrical signals therebetween, thereby enabling smooth signal transmission. For distinguishing from the core via of the second region 222 described later, the core via disposed in the first region 221 will be referred to as the first region core via.

Above the first surface 213 is located on the upper layer 26.

The upper layer 26 comprises an upper distribution layer 25 and an upper surface connection layer 27 located on the upper distribution layer 25, and the uppermost surface of the upper layer 26 may be protected by a cover layer 60 having an opening formed through which the contact electrodes of the semiconductor element can directly contact.

The upper distribution layer 25 comprises an upper insulating layer 253 positioned on the first surface; and an upper distribution pattern 251 embedded in the upper insulating layer 253 as an electrically conductive layer having a predetermined pattern and electrically connecting at least a portion thereof with the core distribution layer 24. The upper distribution layers 25 disposed above and below each other may be connected to each other by blind vias.

The upper insulating layer 253 may be applied as an insulating layer to a semiconductor device or packaging substrate, and may be, for example, an epoxy-based resin comprising fillers, but is not limited to.

The insulating layer may be formed by forming a coating layer and curing it, or it may be formed by laminating an uncured or semi-cured insulating film to the core layer 22 and curing it. In this case, by applying a pressure sensitive lamination method or the like, the insulating material can be embedded into the space inside the core vias 23 and the process can proceed efficiently.

In an embodiment, the plurality of insulating layers may be stacked and substantially indistinguishable between the insulating layers, and the plurality of insulating layers are collectively referred to as the upper insulating layer. Additionally, the core insulating layer 223 and the upper insulation layer 253 may be made of the same insulating material, in which case the boundary between them may be substantially indistinguishable. Alternatively, in other embodiments, the boundaries of the insulator layers may be created by setting different pressures and temperatures to cure the multiple insulating layers.

The upper distribution pattern 251 refers to an electrically conductive layer located within the upper insulating layer 253 in a preset shape, which may be formed, for example, in a build-up layer method.

Specifically, the upper distribution pattern 251 can be formed by operations of forming an insulating layer, removing an unnecessary portion of the insulating layer, forming an electrically conductive layer by copper plating or the like, optionally removing an unnecessary portion of the electrically conductive layer, forming an insulating layer on top of the electrically conductive layer, removing an unnecessary portion of the insulating layer, forming an electrically conductive layer by plating or the like, and so on, so that the electrically conductive layer is formed in a vertical or horizontal direction in the desired pattern.

Since the upper distribution pattern 251 is located between the core layer 22 and the semiconductor element portion 30, it is formed to comprise a fine pattern in at least a portion thereof so that the transmission of electrical signals to the semiconductor element portion 30 may proceed smoothly and the intended complex pattern can be sufficiently accommodated. In this case, the fine patterns may have a width and spacing of less than 4 µm, 3.5 µm or less, 3 µm or less, 2.5 µm or less, or 1 to 2.3 µm, or the like (hereinafter, the description of the fine patterns will be the same).

The upper surface connection layer 27 comprises an upper surface connection pattern 272 electrically connected at least partially to the upper distribution pattern 251 and located on the upper insulating layer 253, and an upper surface connection electrode 271 electrically connecting the upper surface connection pattern 272 to the semiconductor element portion 30. The upper surface connection pattern 272 may be located on one surface of the upper insulating layer 253, or at least a portion thereof may be exposed and embedded in the upper insulating layer. For example, if the upper surface connection pattern is located on one surface of the upper insulating layer, the upper insulating layer may be formed by plating or the like, and if the upper surface connection pattern is embedded with a portion of it exposed on the upper insulating layer, it may be that a portion of the insulating layer or the electrically conductive layer is removed by surface polishing, surface etching, or the like after forming a copper plating layer or the like.

The upper surface connection pattern 272 may comprise, at least in part, a fine pattern, such as the upper substrate pattern 251 described above. The upper surface connection pattern 272 comprising such fine patterns enables a larger number of elements to be electrically connected in a smaller area, allowing for smoother electrical signal connections between elements or to the outside world, and more integrated packaging.

The upper surface contact electrode 271 may be directly connected to the semiconductor element portion 30 by terminals or the like or may be connected via an element connection portion 51 such as a solder ball.

The cavity portion 28 comprises a cavity distribution layer 282 located above and/or below the second region 222 and electrically connected to the core distribution pattern 241, and an internal space 281 in which the cavity elements 40 are located. The cavity distribution layer 282 may be formed through the second region core via 232.

Specifically, the second region 222 has a thinner thickness of the glass substrate 21 compared to the first region 221, and the cavity element 40 may be located in the internal space 281 formed due to the difference in thickness. Furthermore, the core vias 23 and the core distribution layer 24 formed on the glass substrate 21 serve as an electrical connection structure connecting the cavity element 40 and the external element.

Furthermore, as described above, a cavity portion in the form of penetrating the first region 221, i.e., the first surface 213 and the second surface 214 of the glass substrate 1, rather than the second region 222, may be created, and the cavity element 40 may be arranged in the cavity portion.

The packaging substrate 20 is also connected to a motherboard 10. The motherboard 10 may be electrically connected to the core distribution pattern 241 located on at least a portion of the second surface 214 of the core layer 22 by terminals of the motherboard 10, either directly or via a board connection portion 52 such as a solder ball. In addition, the core distribution pattern 241 in contact with the motherboard 10 may be connected to the motherboard 10 via a lower layer (not shown) located at the lower part of the core layer 22. The element connection portion 51 and the board connection portion 52 are collectively referred to as a connection portion 50.

In one example, no substantially additional substrate other than the glass substrate 21 may be applied to the packaging substrate 20 positioned between the semiconductor element portion 30 and the motherboard 10.

Conventionally, an interposer and an organic substrate are laminated together between an element and a motherboard. This multi-step application is understood to be necessary for at least two reasons: one is that there are scale issues with directly connecting the fine pattern of the element to the motherboard, and the other is that wiring damage can occur during the bonding process or during the driving of the semiconductor device due to differences in thermal expansion coefficients. The embodiment solves these problems by applying a glass substrate having a coefficient of thermal expansion similar to that of a semiconductor device and forming a fine pattern on the first surface of the glass substrate and an upper layer thereof having a scale fine enough for mounting the element.

In the following, a manufacturing method for a packaging substrate according to an embodiment of the present invention will be described.

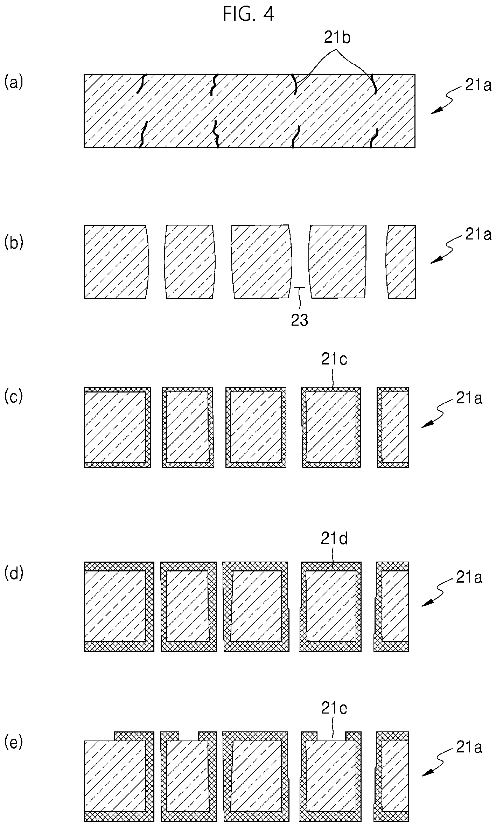

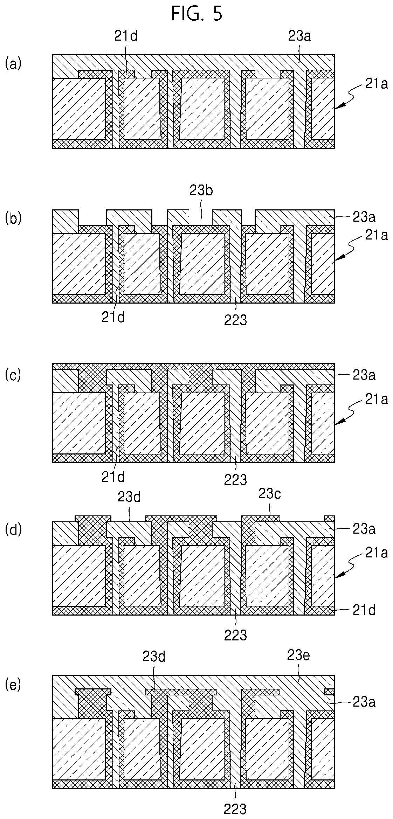

FIGS. 4 and 5 are flowcharts illustrating cross-sectional views of the manufacturing process of a packaging substrate according to an embodiment.

First, a glass substrate 21a having first surface and second surface with flat surfaces is prepared, as shown in (a) of FIG. 4, and a defect (groove, 21b) is formed on the glass surface at a predetermined position for forming a core via. The glass may be a glass substrate applied to a substrate of an electronic device or the like, and may be, for example, an alkali-free glass substrate or the like, but is not limited thereto. Commercially available products manufactured by manufacturers such as Corning, Schott, AGC, and the like may be applied. The formation of the defects (grooves) can be accomplished by mechanical etching, laser irradiation, or the like.

As shown in (b) of FIG. 4, the glass substrate 21a on which the defect (groove, 21b) is formed is subjected to an etching step to form the core vias 23 through a physical or chemical etching process. During the etching process, the glass substrate forms vias at the defects and at the same time the surface of the glass substrate 21a may also be etched. A masking film or the like may be applied to prevent such etching of the glass surface, but in consideration of the cumbersome process of applying and removing the masking film, the glass substrate having the defects itself may be etched, and in this case, the thickness of the glass substrate having the core vias may be somewhat thinner than the thickness of the initial glass substrate.

Then, the core layer preparation operation may be performed by forming an electrically conductive layer 21d on the glass substrate as shown in (c) and (d) of FIG. 4. The electrically conductive layer may be a metal layer comprising copper metal, but not limited to.

The surface of a glass (comprising the surface of a glass substrate and the surface of a core via) and the surface of a copper metal have different properties, and the adhesion between them is relatively poor. In an embodiment, the adhesion between the glass surface and the metal can be improved by two methods, a dry method and a wet method.

The dry method is a method of applying sputtering, that is, metal sputtering, to form a seed layer 21c on the surface of the glass and the inner diameter of the core via. In the formation of the seed layer, dissimilar metals such as titanium, chromium, nickel, and the like may be sputtered together with copper, and in this case, glass-to-metal adhesion may be improved by an anchor effect in which the surface morphology of the glass and the metal particles interact.

The wet method is a primer treatment method in which a primer layer 21c is formed by pretreatment with a compound having functional groups such as amines. Depending on the degree of adhesion desired, pretreatment with a silane coupling agent can be followed by primer treatment with a compound or particle having an amine functional group. As mentioned above, the support substrate of the embodiment needs to be of high enough performance to form a micropattern, which should be maintained after the primer treatment. Therefore, if such primer comprises nanoparticles, it is preferred that nanoparticles having an average diameter of 150 nm or less are applied, for example, particles having amine functional groups. The primer layer can be formed by applying an adhesion force improver, for example, such as the CZ series of MEC.

The seed layer/primer layer 21c may optionally form the electrically conductive layer with or without removing the portion where the formation of the electrically conductive layer is unnecessary. Furthermore, the seed layer/primer layer 21c may be optionally treated in an activated or deactivated state for metal plating with or without removing the portion where the formation of the electrically conductive layer is necessary or unnecessary to proceed with the subsequent process. For example, the activation or deactivation treatment may be subjected to light irradiation treatment such as a laser of a certain wavelength, chemical treatment, or the like. The formation of the metal layer may comprise, but is not limited to, copper plating methods applied in the manufacture of semiconductor devices.

As shown in (e) of FIG. 4, a portion of the core distribution layer may be removed if it is unnecessary, and after the seed layer is partially removed or inactivated, metal plating may be performed to form an electrically conductive layer in a predetermined pattern to form the etching layer 21e of the core distribution layer.

FIG. 5 illustrates manufacturing operations to form an insulating layer and an upper distribution layer, according to one embodiment.

As shown in (a) of FIG. 5, the core via may be subjected to operation of an forming an insulating layer in which the void space is filled with an insulating layer after forming the core distribution layer, which is an electrically conductive layer. In this case, the insulating layer applied may be made in the form of a film, for example, by pressure sensitive lamination of the insulating layer in the form of a film. By performing such pressure-sensitive lamination, the insulating layer can be sufficiently impregnated into the void space inside the core vias to form a core insulating layer without void formation.

(b) through (e) of FIG. 5 illustrate operations of manufacturing an upper layer.

The operation of forming an upper layer is to form an upper layer comprising an upper insulating layer and an upper distribution layer on the core layer. The upper insulating layer may be formed by an operation of coating a resin composition forming the insulating layer 23a or of laminating an insulating film, and the simplest method is to laminate an insulating film. The lamination of the insulating film may be carried out by an operation of laminating the insulating film and curing it, in which case, by applying a pressure sensitive lamination method, the insulating resin may be sufficiently impregnated even in a layer in which no electrically conductive layer is formed inside the core via. The upper insulating layer is also applied in direct contact with the glass substrate, at least in part, and thus has sufficient adhesion. Specifically, the glass substrate and the upper insulating layer are preferably characterized by an adhesion test value of 4B or more according to ASTM D3359.

The upper distribution pattern can be formed by repeating the operations of forming the insulating layer 23a, forming the electrically conductive layer 23c in a predetermined pattern, and etching off the unnecessary parts to form the etching layer 23d of the electrically conductive layer, or, in the case of the electrically conductive layers that are formed adjacent to the insulating layer, forming a blind vias 23b on the insulating layer and then proceeding with the plating process. Dry etching methods such as laser etching, plasma etching, and the like, or wet etching methods using a masking layer and an etching solution, can be applied to form the blind vias.

Then, although not shown, an upper surface connection electrode and a cover layer may be formed.

The upper surface connection pattern and the upper surface connection electrode may also be formed by a process similar to the formation of the upper layer. Specifically, it may be formed by forming an etching layer of an insulating layer on the insulating layer 23e, forming an electrically conductive layer thereon, forming an etching layer of an electrically conductive layer, and so on, but it may also be applied by selectively forming only the electrically conductive layer without applying the method of etching. The cover layer may be formed such that an opening (not shown) is formed at a position corresponding to the upper surface connection electrode so that the upper surface connection electrode is exposed and may be directly connected to an electrical connection or a terminal of the element.

Once the upper layer has been prepared, the lower layer may be processed by forming a lower surface connection layer and a cover layer. The lower distribution layer and/or the lower surface connection layer, and optionally the cover layer (not shown), may be formed in a similar manner to the operation of forming the upper surface connection layer and the cover layer described above.

In one embodiment, a packaging substrate comprising a photoelectric sensor (or opto-electric sensor) may be proposed as an embodiment of the packaging substrate.

The photoelectric sensor may also be referred to as a photo sensor or an image sensor. A photoelectric sensor is a device that stores the amount of electric charge according to the intensity of light as information and outputs the stored information according to an external control signal, and is widely used in X-ray detectors, scanners, digital copiers, fingerprint recognition systems, and fax machines, digital cameras, camcorders, personal communication systems (PCS), game devices, security cameras, medical micro-cameras, etc.

Hereinafter, a conventional photo sensor will be described with reference to FIGS. 6 and 7.

FIG. 6 is an exemplary drawing illustrating a packaging substrate comprising a conventional photoelectric sensor and a device 900 having the same.

The device 900 may comprise a sensing portion 930 disposed on a support portion 910 and an optical fiber portion 950 transmitting optical signals and connected to the sensing portion 930. On the packaging substrate at sensing portion, a light transmitting part, a light receiving part, and the like as described hereinafter may be disposed.

FIG. 7 is a conceptual diagram illustrating an exemplary cross-sectional structure of a packaging substrate comprising a conventional photoelectric sensor.

Referring to FIG. 7, Photo-electric elements (photo-electric components) may be formed within a substrate 200. The substrate 200 may have a first surface 200a and a second surface 200b, and circuit elements CX may be formed on the first surface 200a of the substrate 200. The circuit elements CX may comprise a plurality of transistors [e.g., a transfer transistor, a reset transistor, a drive transistor, and/or a selection transistor] that transmit and amplify an electrical signal (e.g., a photoelectric charge) corresponding to the incident light.

Further, referring to FIG. 7, first to fourth upper insulating layers 210, 220, 230, 240 may be formed on the circuit elements CX. Within the first to fourth upper insulating layers 210, 220, 230, 240, vias VI and wires IL may be formed. A second insulating layer 350b may be formed on the fourth upper insulating layer 240.

A packaging substrate comprising a conventional photoelectric sensor, such as that shown in FIG. 7, comprises an electrically connected configuration for transmitting and receiving signals between the photoelectric elements. The electrically connected configuration may be a plug, through-electrode, or through-contact, or the like. The configuration may comprise the circuit elements CX of FIG. 7, insulating films formed on the circuit elements CX, vias VI formed in the insulating films, and wiring IL. In other words, conventional photoelectric sensors require space to form an electrically connected configuration for transmitting and receiving signals between the photoelectric elements, and therefore, there is a limitation in manufacturing the photoelectric sensor compactly to improve the sensing efficiency relative to space.

Accordingly, the present disclosure proposes a packaging substrate comprising a photoelectric sensor using a glass substrate and a manufacturing method of the same. Specifically, embodiments of a packaging substrate are proposed that utilize the property that a glass substrate is capable of transmitting light so that signals of a photoelectric element can be transmitted and received in the form of light energy through the glass substrate. A manufacturing method of a packaging substrate and a packaging substrate utilizing the method of an embodiment enable a packaging substrate comprising a photoelectric sensor to be compactly manufactured. Through it, the amount of photoelectric element signal transmission can be increased relative to the same space compared to a conventional photoelectric sensor, and a photoelectric sensor with improved sensing efficiency and performance can be manufactured in a small space.

FIGS. 8A through 8D are examples of cross-sectional structures of packaging substrates generated in accordance with embodiments. FIGS. 8A through 8D are conceptually simplified drawings to illustrate a packaging substrate generated in accordance with an embodiment, which may be applied what is described in FIGS. 1 through 5 with reference.

For example, referring to FIG. 8A, a core layer of a packaging substrate prepared in accordance with an embodiment comprises a glass substrate 21 having first surface and second surface facing each other.

The glass substrate 21 may comprise a cavity portion 28, wherein the cavity portion 28 may be formed in the form of a recessed surface with only one of first surface or second surface open. Alternatively, the cavity portion 28 may be recessed with openings toward either the first surface or the second surface of the glass substrate 21 or may penetrate through both the first surface and the second surface to provide space for an element to be disposed therein.

The cavity portion 28 may be formed simultaneously with the core via forming operations, or it may be formed independently after the core via is formed or before the core via is forming. Furthermore, referring to FIG. 8A, a light receiving portion (photo interface component, 82) may be disposed in the cavity portion 28. An electrode 63 may be formed on the surface of the glass substrate 21.

Also referring to FIG. 8A, the packaging substrate may comprise an insulating layer formed on a first surface of the glass substrate 21.

The insulating layer may be the upper insulating layer 253 described above. The insulating layer may be any insulating layer for application to a semiconductor device or packaging substrate, such as, but not limited to, an epoxy-based resin with fillers. The insulating layer 62 may comprise an insulating mixture, and the insulating mixture may comprise inorganic particles and polymeric resins.

For example, the insulating layer 62 may comprise Ajinomoto Build-up Film (ABF). The insulating layer may be formed by forming and curing a coating layer, or it may be formed by laminating an uncured or semi-cured film of an insulator film to the core layer and curing it.

Further, referring to FIG. 8A, at least one via VI may be formed in the insulating layer. The width of the via VI formed in the insulating layer may be from about 10 µm to about 500 µm.

For example, the via VI may be manufactured by ablating the insulating layer to a certain width using a laser or the like, and then removing the insulating layer with a laser or the like.

For example, the vias (VI) formed in the insulating layer may be hollow. For example, the via VI formed in the insulating layer may comprise an inert gas or may be vacuumed.

Alternatively, for example, the via VI formed in the insulating layer may be filled with a light-transmissive material. The light-transmissive material may be transparent or may be a material that allows a certain level of light of a particular wavelength applied as a signal to pass through. The light-transmissive material may be a light-transmissive organic material, a light-transmissive inorganic material, a light-transmissive composite material, or the like, for example, a polysilicon (poly-SiO₂) and/or a transparent polymer.

Exemplarily, the light-transmissive material may have a coefficient of thermal expansion of between 10 ppm/°C and 24 ppm/°C. The coefficient of thermal expansion of the light transmissive material may be greater than or equal to 10 ppm/°C, greater than or equal to 12 ppm/°C, or greater than or equal to 15 ppm/°C. The coefficient of thermal expansion of the light-transmissive material may be 24 ppm/°C or less, 20 ppm/°C or less, or 18 ppm/°C or less.

Further, referring to FIG. 8A, a photo-electronic component may be laminated on the insulating layer.

The photoelectric element may refer to a light transmitting portion 81. For example, the light transmitting portion 81 may be formed on an upper surface of the insulating layer formed on the first surface. A portion of a bottom surface of the light transmitting portion 81 may contact the via VI formed in the insulating layer. The light transmitting portion 81 may be connected to the insulating layer by means of an element connection portion 51, such as a solder ball. The light transmitting portion 81 may be connected to a junction electrode located in the insulating layer via an element connection portion 51, such as a solder ball.

Referring to FIG. 8A, the signal in the form of photo-energy output from the light transmitting portion 81 may be transmitted to the light receiving portion 82 by passing through the glass substrate 21, i.e., the signal in the form of photo-energy output from the light transmitting portion 81 may be transmitted to the light receiving portion 82 by passing through the glass substrate 21. Further, for example, the signal in the form of photo-energy output from the light transmitting portion 81 may be transmitted to the light receiving portion 82 bypassing the electrodes. Furthermore, referring to FIG. 8A, an element connection portion 51, such as a solder ball, may be formed on the bottom surface of the light receiving portion 82. The light receiving portion 82 may be connected to the junction electrode via the element connection portion 51.

Furthermore, for example, referring to FIG. 8B, a solder ball-like element connection portion 51 may be formed on the upper surface of the light receiving portion 82 in the core layer of the packaging substrate created according to an embodiment. The light receiving portion 82 may be connected to the junction electrode of the core via formed on the blind surface of the cavity portion 28 of the glass substrate via the element connection portion 51. For example, a signal in the form of light energy output from the light transmitting portion 81 may be transmitted to the light receiving portion 82 bypassing the electrodes.

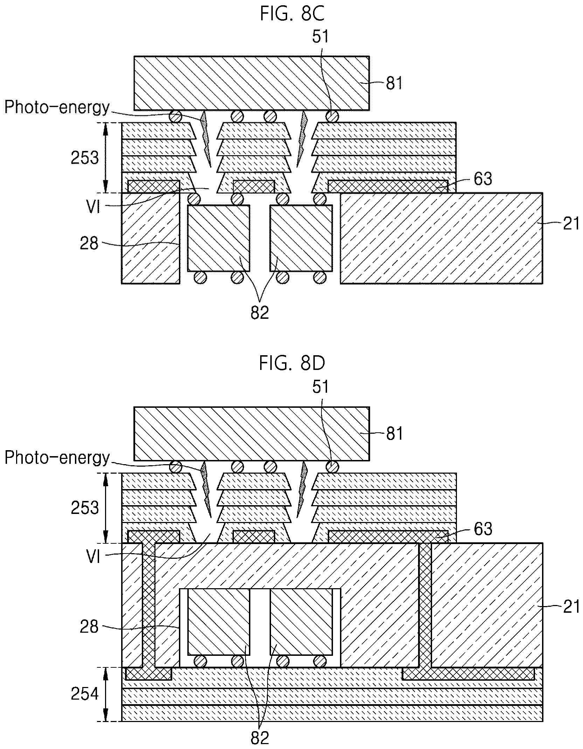

Furthermore, for example, referring to FIG. 8C, the cavity portion 28 of the packaging substrate created according to an embodiment may penetrate the first surface and the second surface of the glass substrate 21 to have a space in which an element is disposed. Furthermore, referring to FIG. 8C, a solder ball-like element connection portion 51 may be formed on the upper surface and the bottom surface of the light receiving portion 82. The light receiving portion 82 may be connected to a junction electrode via the element connection portion 51. For example, a signal in the form of light energy output from the light transmitting portion 81 may be transmitted to the light receiving portion 82 bypassing the electrode.

The light energy signal may comprise visible light or infrared light. Thus, the packaging substrate can be manufactured compactly by reducing the space for the configuration of electrically connecting conventional photoelectric elements, and the sensing efficiency and performance of the photoelectric sensor can be improved relative to the space.

Also, for example, referring to FIG. 8D, a core layer of a packaging substrate created in accordance with an embodiment may comprise a glass substrate 21 having first surface and second surface facing each other.

The glass substrate 21 may comprise a cavity portion 28, wherein the cavity portion 28 may be formed in the form of a recessed surface with only one of the first surface or the second surface open. Alternatively, the cavity portion 28 may be recessed with openings toward either the first surface or the second surface of the glass substrate 21 or may penetrate both the first and the second surfaces to provide space for an element to be disposed therein.

The cavity portion 28 may be formed simultaneously with the core via the same forming operations as the core via, or it may be formed independently after the core via is formed or before the core via is forming. Furthermore, referring to FIG. 8D, a light receiving portion (Photo interface component, 82) may be disposed in the cavity portion 28. An electrode 63 may be formed on the surface of the glass substrate 21.

Further, referring to FIG. 8D, the packaging substrate may comprise an upper insulating layer 253 formed on a first surface of the glass substrate 21 and a lower insulating layer 254 formed on a second surface. The insulating layer may comprise the upper insulating layer 253 and the lower insulating layer 254.

The insulating layer may be applicable when applied as an insulator layer to a semiconductor device or packaging substrate, and may comprise, for example, but is not limited to, an epoxy-based resin with fillers. The insulating layer may comprise an insulating mixture, and the insulating mixture may comprise inorganic particles and polymeric resins. For example, the insulating layer may comprise Ajinomoto Build-up Film (ABF). The insulating layer may be formed by forming and curing a coating layer, or it may be formed by laminating an uncured or semi-cured film of an insulator film to the core layer and curing it.

Further, referring to FIG. 8D, at least one via VI may be formed in the upper insulating layer 253 and/or the lower insulating layer 254. The width of the via VI created in the upper insulating layer 253 and/or the lower insulating layer 254 may be from about 10 µm to about 500 µm. For example, the via VI may be created by ablating the upper insulating layer 253 and/or the lower insulating layer 254 to a certain width using a laser or the like, and then removing a portion of the upper insulating layer and/or the lower insulating layer using a laser. Alternatively, it may be generated by removing a portion of the surface of the glass substrate 21 along with the above insulating layers.

A detailed description of the inner parts of the via VI formed in the above insulating layer is redundant to the description given above, and therefore is omitted.

Further, referring to FIG. 8D, a photo-electronic component may be laminated on the upper insulating layer 253. The photo-electronic component may refer to the light transmitting portion 81. For example, the light transmitting portion 81 may be formed on an upper surface of the upper insulating layer 253. A portion of the bottom surface of the light transmitting portion 81 may abut the vias formed in the upper insulating layer 253. The light transmitting portion 81 may be connected to the upper insulating layer 253 via an element connection portion 51 such as a solder ball.

Referring to FIG. 8D, a signal in the form of photo-energy output from the light transmitting portion 81 may pass through the glass substrate 21 to the light receiving portion 82.

In other words, a signal of photo-energy output from the light transmitting portion 81 can pass through the glass substrate 21 and be transmitted to the light receiving portion 82. The description of the photo-energy signal is redundant to the description given above, and therefore will not be described in detail.

However, an embodiment in which the light transmitting portion 81 and the light receiving portion 82 are disposed opposite to each other as shown in FIG. 8A may also be proposed. An embodiment in which the light transmitting portion 81 and light receiving portion 82 are disposed opposite to each other as shown in FIG. 8A will be described in detail in FIGS. 9A to 9D hereinafter.

FIGS. 9A through 9D are examples of cross-sectional views of a packaging substrate generated according to another embodiment. FIGS. 9A through 9D are conceptually simplified drawings to illustrate a packaging substrate generated according to an embodiment, to which the teachings described with reference to FIGS. 1 through 5 may apply.

For example, referring to FIG. 9A through 9D, a core layer of a packaging substrate created in accordance with an embodiment may comprise a glass substrate 21 having first and second surfaces facing each other.

The glass substrate 21 may comprise a cavity portion 28, wherein the cavity portion 28 may be formed in the form of a recessed surface with only one of the first surface or the second surface open. Alternatively, the cavity portion 28 may be recessed with openings toward either the first surface or the second surface of the glass substrate 21 or may penetrate through both the first surface and the second surface to provide space for an element to be disposed therein.

The cavity portion 28 may be formed simultaneously with the core via through the same forming operations of the core via or may be formed independently after the core via is formed or before the core via is forming. Furthermore, referring to FIGS. 9A to 9D, the cavity portion 28 may be disposed with a light transmitting portion 81. An electrode 63 may be formed on the surface of the glass substrate 21. Further, referring to FIGS. 9A to 9D, a light receiving portion 82 may be laminated on the insulating layer. For example, the light receiving portion 82 may be formed on the upper surface of the insulating layer formed on the first surface. A portion of the bottom surface of the light receiving portion 82 may abut the via VI formed in the insulating layer. The light receiving portion 82 may be connected to the insulating layer by means of an element connection portion 51, such as a solder ball. The light receiving portion 82 may be connected to a junction electrode located in the insulating layer via a solder ball.

Referring to FIGS. 9A to 9D, a signal in the form of photo-energy output from the light transmitting portion 81 may be transmitted to the light receiving portion 82 by passing through the glass substrate 21, i.e., a signal in the form of photo-energy output from the light transmitting portion 81 may be transmitted to the light receiving portion 82 by passing through the glass substrate 21. Also, for example, the signal in the form of photo-energy output from the light transmitting portion 81 may be transmitted to the light receiving portion 82 bypassing the electrodes.

Furthermore, referring to FIG. 9A, an element connection portion 51 such as a solder ball may be formed on the bottom surface of the light transmitting portion 81. The light transmitting portion 81 may be connected to the junction electrode via the element connection portion 51.

Furthermore, for example, referring to FIG. 9B, a solder ball-like element connection portion 51 may be formed on the upper surface of the light transmitting portion 81 in the core layer of the packaging substrate produced according to an embodiment. The light transmitting portion 81 may be connected to the junction electrode of the core via formed on the blind surface of the cavity portion 28 of the glass substrate via the element connection portion 51. For example, a signal in the form of light energy output from the light transmitting portion 81 may be transmitted to the light receiving portion 82 bypassing the electrodes.

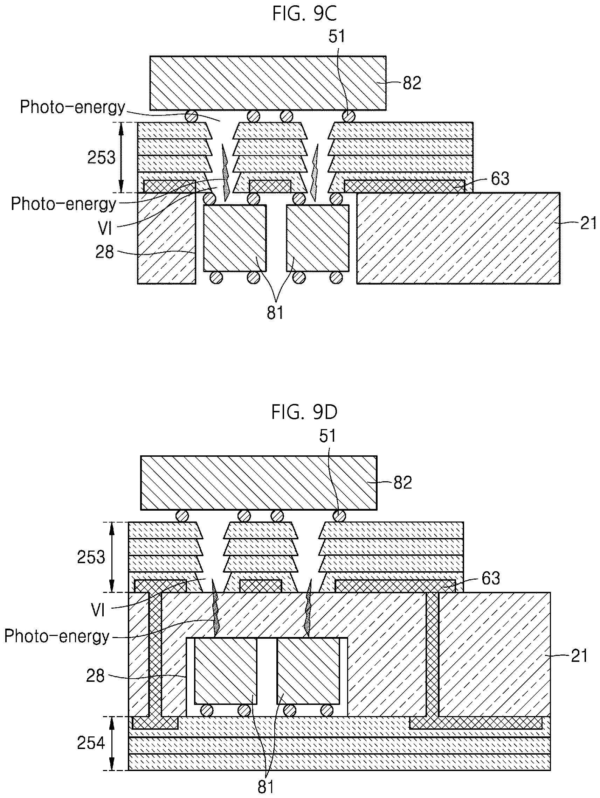

Further, for example, referring to FIG. 9C, the cavity portion 28 of the packaging substrate created according to an embodiment may penetrate the first surface and the second surface of the glass substrate 21 to have a space in which an element is disposed. Furthermore, referring to FIG. 9C, an element connection portion 51 such as a solder ball may be formed on the upper surface and the lower surface of the light transmitting portion 81. The light transmitting portion 81 may be connected to the connection electrode via the element connection portion 51. For example, a signal in the form of light energy output from the light transmitting portion 81 may be transmitted to the light receiving portion 82 bypassing the electrode.

Further, for example, referring to FIG. 9D, the packaging substrate may comprise an upper insulating layer 253 formed on a first surface of the glass substrate 21 and a lower insulating layer 254 formed on a second surface. The insulating layer may comprise the upper insulating layer 253 and the lower insulating layer 254.

The insulating layer may be applicable when applied as an insulator layer to a semiconductor device or packaging substrate, and may comprise, for example, but is not limited to, an epoxy-based resin with fillers. The insulating layer may comprise an insulating mixture, and the insulating mixture may comprise inorganic particles and polymeric resins. For example, the insulating layer may comprise Ajinomoto Build-up Film (ABF). The insulating layer may be formed by forming and curing a coating layer, or it may be formed by laminating an uncured or semi-cured film of an insulator film to the core layer and curing it.

The specific description of the light energy signal is redundant to the description given above, and therefore the detailed description is omitted.

The present disclosure also proposes manufacturing methods for generating a packaging substrate according to the embodiments disclosed in FIGS. 8A through 8D and FIGS. 9A through 9D. For example, a manufacturing method for generating a packaging substrate in accordance with an embodiment of the present disclosure may comprise:

For example, a cavity 28 may be created in the glass substrate 21 having first and second surfaces facing each other. The cavity 28 may be formed in the form of a recessed surface in which only one of the first surface or second surface is open. The cavity portion 28 may be formed in the form of a recessed surface in which only one of the first surface or second surface is open to provide space for the element to be disposed. Alternatively, the cavity portion 28 may be recessed with openings toward either the first surface or the second surface of the glass substrate 21 or may be recessed through both the first and the second surfaces to provide space for an element to be disposed.

Subsequently, a light receiving portion (Photo interface component, 82) or a light transmitting portion 81 may be disposed in the cavity portion 28.

Next, an insulating layer may be formed on the first surface. For example, a glass substrate 21 with an insulating layer formed on the first surface may be provided. For example, a process of lamination on top of the insulating layer may be performed on the first surface. Alternatively, an insulating layer may be formed on the first surface and the second surface. For example, a glass substrate 21 may be provided in which an upper insulating layer is formed on the first surface and a lower insulating layer is formed on the second surface. For example, a process may be performed in which the insulating layer is laminated to the first surface and the second surface. Here, for example, the light receiving portion 82 or light transmitting portion 81 may be connected to the lower insulating layer by means of an element connection portion 51 such as a solder ball. For example, the insulating layer may comprise an insulating mixture, the insulating mixture may comprise inorganic particles and a polymeric resin. For example, the insulating layer may comprise an Ajinomoto Build-up Film (ABF) as described above.

Next, a via VI may be created in the insulating layer. For example, the insulating layer formed on the first surface may be ablated to a certain width using a laser or the like, and the glass substrate 21 may be cut using a laser or a dicing saw to create a via VI in the insulating layer. The width of the via VI created in the insulating layer may be from about 10 µm to about 500 µm. Alternatively, for example, the upper insulating layer may be ablated to a certain width using a laser or the like, and the glass substrate 21 may be cut using a laser to create the via VI in the upper insulating layer, and the lower insulating layer may be ablated to a certain width using a laser or the like, and the glass substrate 21 may be cut using a laser to create the via VI in the lower insulating layer. The width of the via VI generated in the upper insulating layer 253 and the lower insulating layer 254 may be from about 10 µm to about 500 µm.

A detailed description of the interior of the via VI formed in the above insulating layer is redundant to the description given above, and therefore is omitted.

Next, the light transmitting portion 81 or light receiving portion 82 may be laminated to the insulating layer. For example, the light transmitting portion 81 or light receiving portion 82 may be laminated to the insulating layer formed on the first surface. For example, the light transmitting portion 81 or light receiving portion 82 may be laminated to an upper insulating layer formed on the first surface, i.e., for example, the light transmitting portion 81 or light receiving portion 82 may be formed on an upper surface of the insulating layer formed on the first surface. The light transmitting portion 81 may comprise a photo-electric component. A portion of the bottom surface of the light transmitting portion 81 or light receiving portion 82 may contact the via VI formed in the insulating layer (or, for example, in the upper insulating layer). The light transmitting portion 81 or light receiving portion 82 may be connected to the insulating layer by means of an element connection portion 51, such as a solder ball.

For example, a signal in the form of photo-energy output from the light transmitting portion 81 may pass through the glass substrate 21 and be transmitted to the light receiving portion 82, i.e., a photo-energy signal output from the light transmitting portion 81 may pass through the glass substrate 21 and be transmitted to the light receiving portion 82. The photo-energy signal may comprise visible light or infrared light.

The method of manufacturing a packaging substrate according to the embodiments described above and the packaging substrate utilizing the method of manufacturing the packaging substrate may result in a compactly manufactured packaging substrate by reducing the space for configurations for electrically connecting conventional photoelectric elements, thereby improving the sensing efficiency and performance of the photoelectric sensor relative to space.

The manufacturing method of a packaging substrate and the packaging substrate utilizing the method according to the embodiments can reduce the space for electrical connection structures between photoelectric elements by utilizing the glass substrate's ability to pass signals in the form of light energy, thereby enabling the packaging substrate containing the photoelectric sensor to be compactly manufactured.

In addition, by increasing the amount of photoelectric element signal transmission relative to the same space compared to conventional photoelectric sensors, the sensing efficiency and performance of photoelectric sensors can be greatly improved with a small space.

The above-described disclosure has been described with reference to the embodiments shown in the drawings, but these are exemplary only, and those having ordinary knowledge in the art will understand that various modifications and variations of the embodiments are possible from them. In other words, the scope of the disclosure is not limited to the embodiments described above, but also to various modifications and improvements of the embodiments and embodiments of those skilled in the art utilizing the basic concepts of the embodiments defined in the following claims. Accordingly, the true technical scope of the disclosure is to be determined by the technical ideas of the appended claims.

## Claims

1. A packaging substrate, comprising
a core layer comprising a glass substrate having first surface and second surface facing each other and a cavity portion;
an insulating layer formed on the first surface; and
a light transmitting portion formed on the upper surface of the insulating layer,
wherein a light receiving portion is disposed in the cavity portion,
the insulating layer comprises a via penetrating in a thickness direction, and
a portion of a bottom surface of the light transmitting portion abuts the via.

2. The packaging substrate of Claim 1,
wherein a signal of photo-energy output from the light transmitting portion passes through the glass substrate to the light receiving portion.

3. The packaging substrate of Claim 2,
wherein the signal of photo-energy comprises visible light or infrared light.

4. The packaging substrate of any one from Claim 1 to Claim 3,
wherein the vias have a width of 10 µm to 500 µm.

5. The packaging substrate of any one from Claim 1 to Claim 4,
wherein the vias comprise a vacuum or an inert gas.

6. The packaging substrate of any one from Claim 1 to Claim 5,
wherein the via comprises a light-transmissive material, and
the light-transmissive material has a coefficient of thermal expansion of 10 to 24 ppm/°C.

7. The packaging substrate of any one from Claim 1 to Claim 6,
wherein the cavity portion is open in the direction of the second surface of the glass substrate and is formed in the form of a recessed surface, having a space in which the light receiving portion is disposed.

8. A manufacturing method of a packaging substrate, comprising operations of,
creating a cavity portion in a glass substrate with first surface and second surface facing each other;
placing a light receiving portion in the cavity portion;
forming an insulating layer on the first surface;
creating a via in the insulating layer; and
laminating a light transmitting portion to the insulating layer,
wherein a portion of a lower surface of the light transmitting portion abuts on the via.

9. The manufacturing method of a packaging substrate of Claim 8,
wherein a signal of photo-energy output from the light transmitting portion passes through the glass substrate to the light receiving portion.

10. The manufacturing method of a packaging substrate of Claim 9,
wherein the signal of photo-energy comprises visible or infrared light.
